# EUROPEAN PATENT SPECIFICATION

(11) **EP 2 918 703 B1**
(45) Date of publication and mention of the grant of the patent: **24.10.2018**
(21) Application number: 13853061.3
(22) Date of filing: 07.11.2013
(51) Int. Cl.: C23C 16/509, B65D 23/02, H01J 37/32, C23C 16/04, C23C 16/503

(54) **RESIN CONTAINER COATING DEVICE**
BESCHICHTUNGSVORRICHTUNG FÜR HARZBEHÄLTER
DISPOSITIF DE REVÊTEMENT DE RÉCIPIENT DE RÉSINE

(30) Priority: 08.11.2012 JP 2012246499
(43) Date of publication of application: 16.09.2015
(73) Proprietor: Nissei Asb Machine Co., Ltd., Komoro-shi, Nagano 384-8585 (JP)
(72) Inventor: SHIMADA Kiyonori, Komoro-shi Nagano 384-8585 (JP)
(74) Representative: Addiss, John William
(86) International application number: PCT/JP2013/080124
(87) International publication number: WO 2014/073609

(56) References cited:
- EP-A1- 1 516 941
- JP-A- 2005 350 145
- JP-A- 2007 016 300
- JP-B2- 2 788 412
- US-A1- 2006 099 340

## Description

### Technical Field

The present invention relates to a resin container coating device capable of disposing a plurality of resin containers in a chamber and performing collective film formation.

### Background Art

Resins such as polyethylene, which are widely used in household goods and the like, generally have a property of transmitting a low-molecular gas such as oxygen or carbon dioxide and also a property of sorbing a low-molecular organic compound inside thereof. Therefore, when the resin is used as a container, it is known that there are various restrictions on its use target and use form as compared with other containers such as glass. For example, in a case of using a resin container by filling carbonated drinking water therein, since the carbonic acid permeates through the container to the outside, it may be difficult in some cases to maintain the quality as the carbonated drinking water for a long period of time.

Accordingly, at the time of producing a resin container, in order to solve troubles caused by the permeation of a low-molecular gas in the resin container and the sorption of a low-molecular organic compound, it is known to form a film such as DLC (Diamond Like Carbon) coating on an inner surface of the resin container by a plasma CVD film-forming technique (for instance, see patent document 1). Furthermore, from a requirement of improving production efficiency in recent years, a device for collectively forming this kind of coating on a plurality of resin containers is also known (for instance, see patent document 2).

### Prior Art Documents

### Patent Documents

Patent document 1: Japanese Patent JP2788412B
Patent document 2: Japanese Patent JP4567442B

EP1516941 A discloses a resin container coating device comprising a plurality of chambers comprising a switching system to direct the HF power to different sets of chambers.

### Summary of the Invention

### Problem that the Invention is to Solve

When the film is formed collectively in the plurality of containers, if an electric power of a high frequency power source is insufficient, dispersion occurs in the quality of the film formed in the inner surface of the resin container. In order to uniformly form the film having a good quality with a predetermined barrier performance in the resin container, a minimum electric power is necessary depending on conditions such as the size and the form of the container. However, to supply a sufficient electric power to the plurality of resin containers, a large high frequency power source is necessary. Thus, a cost of the device will be increased.

It is an object of the present invention to provide a resin container coating device which can suppress enlargement in a high frequency power source and improve production efficiency.

### Means for Solving the Problem

A resin container coating device of the present invention includes a plurality of chambers serving as a plurality of outer electrodes which are mutually electrically independent and storing a plurality of resin containers respectively in independent states, a plurality of internal electrodes which are electrically grounded and formed in a tubular shape, in which gas conductive parts for conducting a source gas are formed to inner peripheral parts thereof, and which are respectively inserted inside the plurality of resin containers stored in the chambers, a gas supply unit for supplying the source gas to the plurality of chambers, a high frequency power source for supplying a high frequency electric power to the plurality of chambers, and an electric power switching part capable of switching a supply designation of the high frequency electric power, which is supplied from the high frequency power source, from a part of the plurality of chambers to another chamber.

The resin container coating device of the present invention includes a gas switching part capable of switching a supply destination of the source gas, which is supplied from the gas supply unit, from a part of the plurality of chambers to another chamber.

### Advantage of the Invention

According to the resin container coating device of the present invention, a film forming process by the generation of plasma can be sequentially carried out to the plurality of chambers. Namely, initially, the high frequency electric power is supplied to a part of the plurality of chambers to carry out the film forming process to the resin containers stored in the part of the chambers. Then, the supply destination of the high frequency electric power is switched by the electric power switching part, and the source gas is supplied by a gas switching part corresponding to the HF power switching, and the film forming process can be carried out to the resin containers stored in the remaining chambers. In such a way, the film forming process is sequentially carried out respectively for predetermined units of the plurality of chambers. Thus, the high frequency electric power required for the film forming process at one time is suppressed and the high frequency power source does not need to be enlarged.

Further, for instance, since common pretreatments such as a process of evacuating the plurality of chambers or a process of supplying the source gas to the plurality of chambers can be carried out together to the plurality of chambers at the same time, production efficiency can be improved.

### Brief Description of the Drawings

Fig. 1 is a front sectional view which explains a first embodiment of a resin container coating device according to the present invention.
Fig. 2 is a side sectional view of the resin container coating device shown in Fig. 1.
Fig. 3 is an enlarged sectional view of main parts of a chamber shown in Fig. 1.
Fig. 4 is a schematic diagram showing an electric connection structure and a piping structure of the first embodiment.
Fig. 5 is a flowchart which explains a coating procedure of the first embodiment.
Fig. 6 is a schematic diagram which explains an electric connection structure and a piping structure of a second embodiment.
Fig. 7 is a schematic diagram which explains an electric connection structure and a piping structure of a third embodiment.

### Modes for Carrying Out the Invention

Now, embodiments of a resin container coating device according to the present invention will be respectively described below by referring to the drawings.

### (First Embodiment)

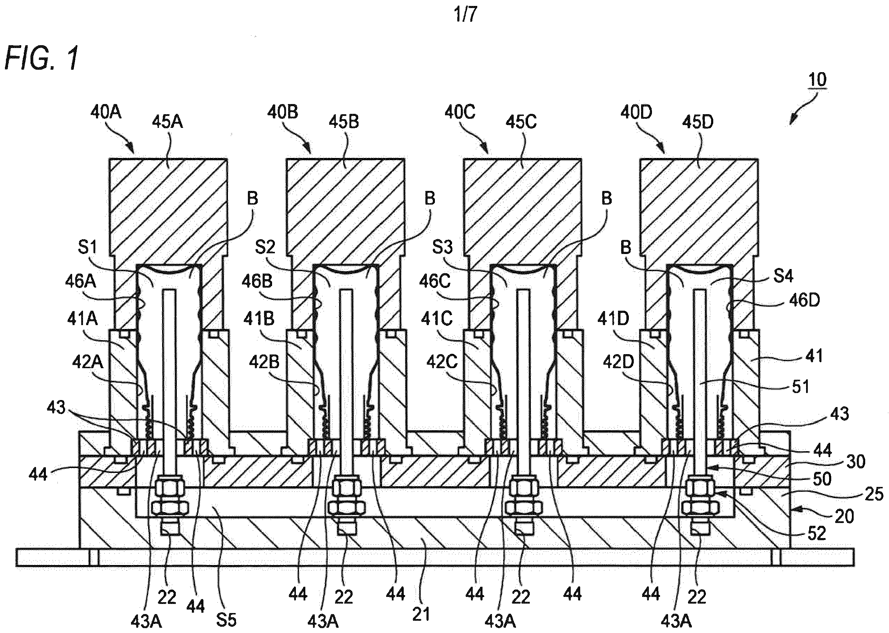

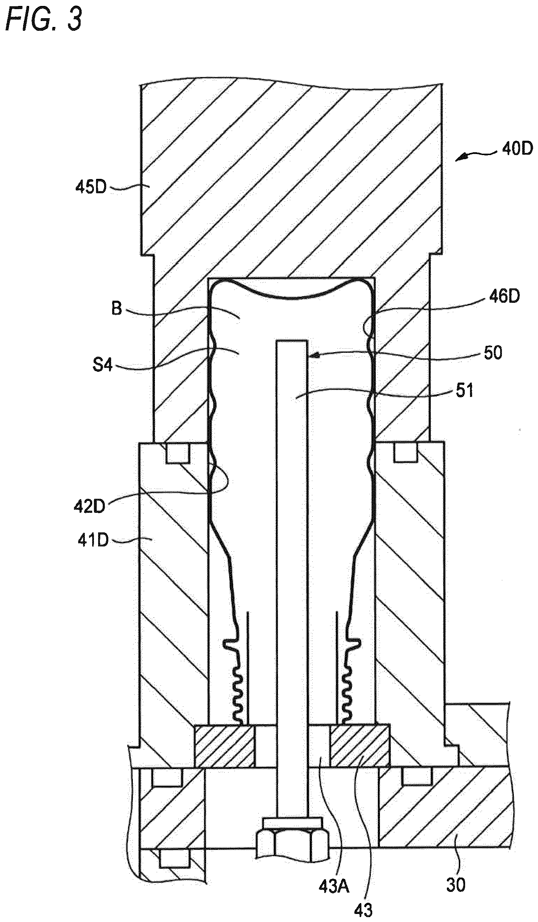

Initially, a first embodiment of the resin container coating device according to the present invention will be described below by referring to Fig. 1 to Fig. 5.

The resin container coating device (hereinafter, also referred to as a "coating device") is a device in which resin containers are respectively stored in a plurality of chambers to produce films configured by gas of a silicon compound, etc., on their inner surfaces by using a plasma CVD technique.

Bottles for drinking water such as carbonic acid beverage or fruit juice, containers for toilet goods or chemicals may be exemplified as the resin containers. However, the present invention is not limited thereto and resin containers may be adopted which are used for other uses.

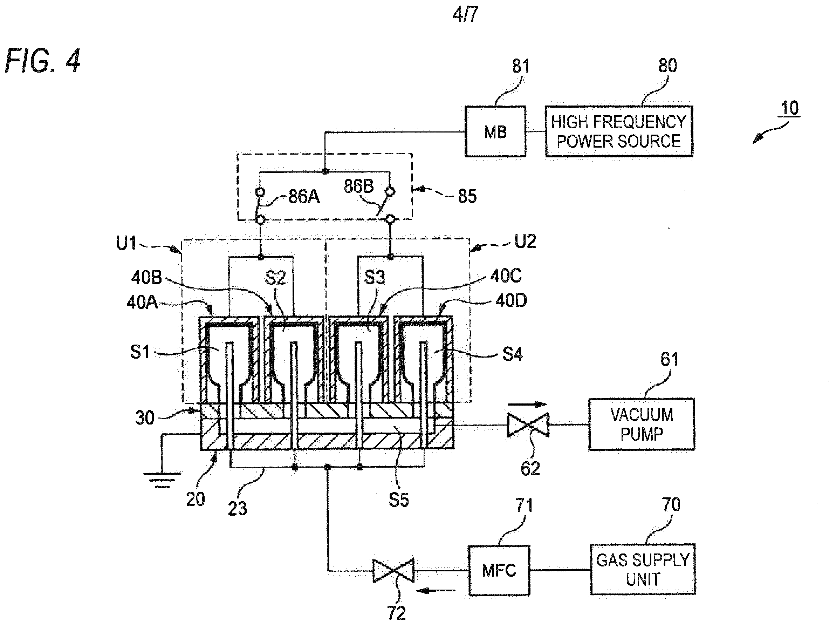

The coating device 10 of the present embodiment includes, as shown in Fig. 1 to Fig. 3, a base part 20 as a base, a flat plate shaped insulating plate 30 arranged on the base part 20, first, second, third and fourth chambers 40A, 40B, 40C and 40D which are arranged on the insulating plate 30 and respectively have four first, second, third and fourth storage rooms S1, S2, S3 and S4 to store a plurality of (four in the present embodiment) substantially cylindrical resin containers B respectively in individually independent states, pipe shaped (tubular) internal electrodes 50 respectively inserted and arranged in the plurality of resin containers B respectively installed in the storage rooms S1, S2, S3 and S4, an exhaust unit 60 which communicates respectively with the storage rooms S1, S2, S3 and S4 of the chambers 40A, 40B, 40C and 40D to exhaust air and a gas supply unit 70 (see Fig. 4) which supplies source gas to the resin containers B installed in the storage rooms S1, S2, S3 and S4 of the chambers 40A, 40B, 40C and 40D.

The base part 20 is formed with a metal block such as stainless steel and includes a rectangular bottom plate part 21 and a peripheral wall part 25 which extends upward from a peripheral edge of the bottom plate part 21. An inner space S5 is defined by the bottom plate part 21, the peripheral wall part 25 and the insulating plate 30. Further, in an upper surface part of the bottom plate part 21 of the base part 20, four screw holes 22 are provided substantially at equal intervals in a linearly parallel state. Further, in the bottom plate part 21 of the base part 20, four gas passage paths 23 are provided. The gas passage paths 23 are respectively connected to the gas supply unit 70 at an upstream end and respectively connected to the screw holes 22 at a downstream end. Further, the base part 20 is electrically grounded (see Fig. 4).

The first, second, third and fourth chambers 40A, 40B, 40C and 40D respectively include first, second, third and fourth chamber bodies 41A, 41B, 41C and 41D and first, second, third and fourth chamber lids 45A, 45B, 45C and 45D respectively detachably attached to upper parts of the chamber bodies 41A, 41B, 41C and 41D to seal the chamber bodies 41A, 41B, 41C and 41D. These chambers 40A, 40B, 40C and 40D also respectively function as outer electrodes of a plasma CVD and are electrically connected to a high frequency power source 80 (see Fig. 4) through a matching box 81 and an electric power switching part 85, which will be described later. The chamber bodies 41A, 41B, 41C and 41D are respectively formed with rectangular metal blocks and respectively have circular through holes 42A, 42B, 42C and 42D formed so as to have inside diameters a little larger than an outer shape of the resin containers B.

These through holes 42A, 42B, 42C and 42D are provided in a linearly parallel state and respectively communicate with the inner space S5 of the base part 20. In lower parts of the through holes 42A, 42B, 42C and 42D, one flat plate shaped container holding plate 43 is arranged. In the container holding plates 43, four opening parts 43A are formed which have diameters slightly smaller than those of openings of the resin containers B at positions respectively corresponding to the though holes 42A, 42B, 42C and 42D. Since the resin containers B respectively stored in the storage rooms S1, S2, S3 and S4 are held by peripheral parts of the opening parts 43A of the container holding plates 43, the accommodated resin containers B do not slip off from the through holes 42A, 42B, 42C and 42D. Further, in the container holding plates 43, a plurality of air exhaust openings 44 are provided. Thus, air in inner parts and outer parts of the resin containers B respectively stored in the storage rooms S1, S2, S3 and S4 can be evacuated at the same time.

In the chamber lids 45A, 45B, 45C and 45D, bottomed holes 46A, 46B, 46C and 46D which mutually have the same diameters are respectively formed at positions corresponding to the through holes 42A, 42B, 42C and 42D of the chamber bodies 41A, 41B, 41C and 41D under a state that the chamber lids 45A, 45B, 45C and 45D are respectively aligned with the chamber bodies 41A, 41B, 41C and 41D. Namely, under the state that the chamber bodies 41A, 41B, 41C and 41D are respectively aligned with the chamber lids 45A, 45B, 45C and 45D, the storage rooms S1, S2, S3 and S4 which store the resin containers B are formed and arranged in a linearly parallel state by the through holes 42A, 42B, 42C and 42D of the chamber bodies 41A, 41B, 41C and 41D and the bottomed holes 46A, 46B, 46C and 46D of the chamber lids 45A, 45B, 45C and 45D.

The internal electrode 50 is a hollow and tubular pipe member such as a metallic cylinder or a rectangular tube and has a gas conductive part 51 which guides the source gas in an inner peripheral part thereof. The internal electrodes 50 are respectively introduced to the storage rooms S1, S2, S3 and S4 via the opening parts 43A of the container holding plates 43. Lower parts of the internal electrodes 50 are screwed and connected to the screw holes 22 of the base part 20 through metallic piping members 52. Thus, the internal electrodes 50 are respectively inserted into the storage rooms S1, S2, S3 and S4 of the chambers 40A, 40B, 40C and 40D and arranged so as to be located at central parts of the storage rooms S1, S2, S3 and S4. Further, at this time, since the base part 20 is electrically grounded, the internal electrodes 50 are electrically grounded as a result of their screwing and connection. Further, at the same time, since the screw holes 22 communicate with the gas passage paths 23 in the base part 20, the gas conductive parts 51 of the internal electrodes 50 are consequently connected to the gas passage paths 23 of the base part 20 and the gas supply unit 70 (see Fig. 4).

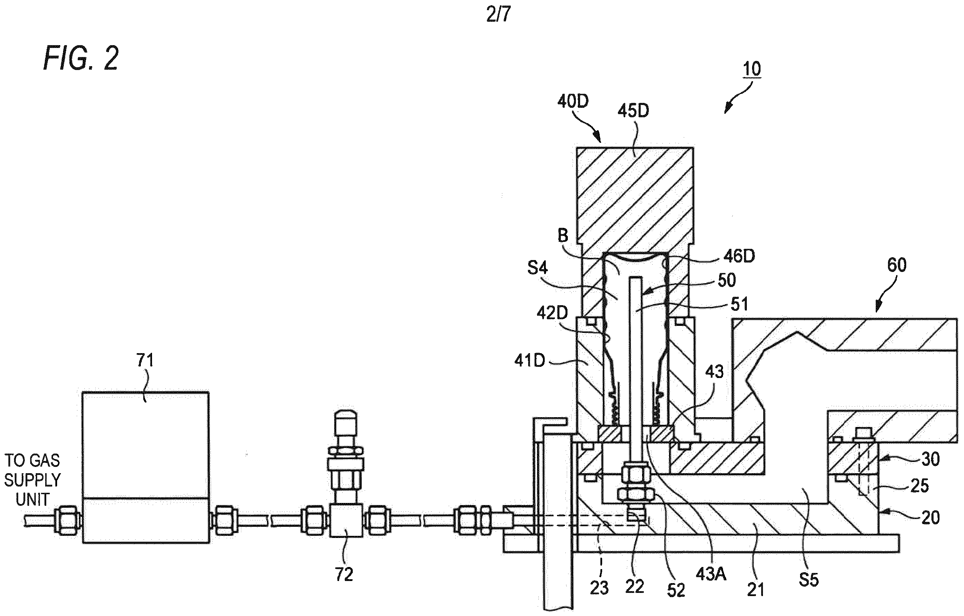

Further, in a peripheral part of the gas supply unit 70, between the gas passage path 23 of the base part 20 and the gas supply unit 70, an on-off valve 72 and a mass flow controller 71 are arranged as shown in Fig.2 and Fig. 4. The on-off valve 72 is arranged in the gas passage path side of the base part 20 and the mass flow controller 71 is arranged in the gas supply unit 70 side.

As shown in Fig. 2, since the exhaust unit 60 communicates with the inner space S5 of the base part 20, the exhaust unit 60 resultantly communicates with the storage rooms S1, S2, S3 and S4 of the chambers 40A, 40B, 40C and 40D. Further, the exhaust unit 60 is connected to a vacuum pump 61 in a downstream side. By the vacuum pump 61, air of the storage rooms S1, S2, S3 and S4 of the chambers 40A, 40B, 40C and 40D is exhausted through the inner space S5 (see Fig. 4).

Here, between the vacuum pump 61 and the inner space S5, an on-off valve 62 is arranged.

In the present embodiment, the first and second chambers 40A and 40B form a first unit U1 so as to form an electrically integral parallel circuit unit as shown in Fig. 4. Similarly, the third and fourth chambers 40C and 40D form a second unit U2 so as to electrically form an electrically integral parallel circuit unit. In addition thereto, the first and second units U1 and U2 themselves are electrically connected in parallel with the high frequency power source 80.

Between the first and second units U1 and U2 and the high frequency power source 80, the electric power switching part 85 is arranged. The electric power switching part 85 is electrically connected to the high frequency power source 80 through the matching box 81. Further, the electric power switching part 85 includes first and second switch circuits 86A and 86B. The first switch circuit 86A is electrically connected to the first unit U1. The second switch circuit 86B is electrically connected to the second unit U2. The first and second switch circuits 86A and 86B carry out alternately opening and closing operations of an electric power in accordance with an instruction of the electric power switching part 85. For instance, when the first switch circuit 86A is closed to supply the electric power to the first unit U1, the second switch circuit 86B is opened not to supply the electric power to the second unit U2. Thus, the electric power switching part 85 has a function that alternately switches a supply destination of the high frequency electric power, which is supplied from the high frequency power source 80, between the first and second units U1 and U2.

The matching box 81 serves to realize an impedance matching between the high frequency power source 80 and the first and second units U1 and U2. The matching box is formed with a matching circuit having a combination of electric elements such as a coil and a capacitor.

The quality of the film formed in the resin container B depends on a plurality of factors such as an output of high frequency of the high frequency power source 80, a pressure of the source gas in the resin container B, a flow rate of the source gas, a time of generation of plasma or the like. In the present embodiment, in order to suppress an unevenness in the quality of the film of the resin container B between the storage rooms S1, S2, S3 and S4, the above-described electric power switching part 85 is provided to concentrate the electric power supplied from the high frequency power source 80 to a part of the chambers 40A, 40B, 40C and 40D, more specifically, for each of units of the first or second unit U1 or U2.

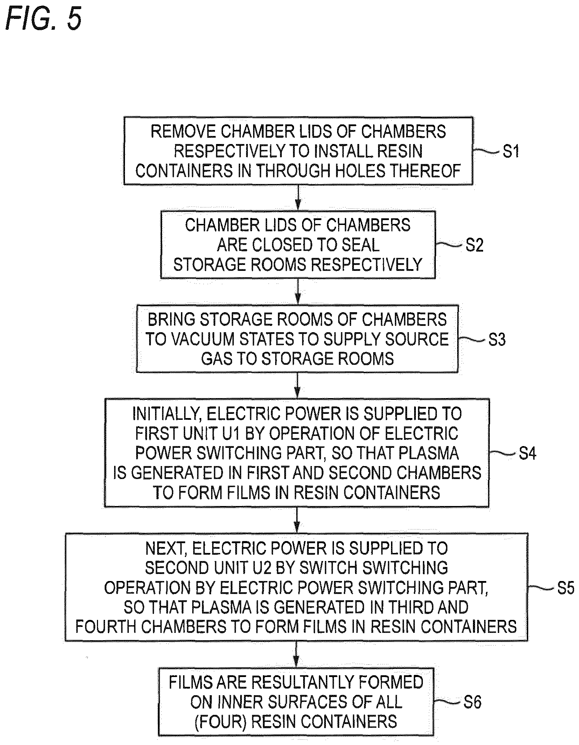

Further, a film forming method using the coating device 10 configured as described above will be described below by referring to Fig. 5.

Initially, under a state that the chamber lids 45A, 45B, 45C and 45D of the chambers 40A, 40B, 40C and 40D are respectively removed, the plurality of resin containers B are inserted into the through holes 42A, 42B, 42C and 42D of the chamber bodies 41A, 41B, 41C and 41D from upper parts and are respectively stored. At this time, since the through holes 42A, 42B, 42C and 42D have inside diameters a little larger than diameters of the maximum cylinder diameter of the resin containers B, the resin containers B are held at predetermined positions in the through holes 42A, 42B, 42C and 42D (step S1).

At this time, the internal electrodes 50 are respectively inserted into the resin containers B from openings of the resin containers B.

After that, the chamber lids 45A, 45B, 45C and 45D of the chambers 40A, 40B, 40C and 40D are closed to respectively seal the storage rooms S1, S2, S3 and S4 of the chambers 40A, 40B, 40C and 40D (step S2).

Then, the air in the chambers 40A, 40B, 40C and 40D is exhausted by the vacuum pump 61 of the exhaust unit 60 so that the storage rooms S1, S2, S3 and S4 of the chambers 40A, 40B, 40C and 40D are brought to states similar to a vacuum (hereinafter, also referred to as a vacuum state). After the vacuum state is recognized, the mass flow controller 71 and the on-off valve 72 operate so that the source gas is continuously supplied by the gas supply unit 70. The supplied source gas passes the gas conductive parts 51 of the internal electrodes 50 to discharge the source gas from ends of the internal electrodes 50. Thus, the source gas is supplied to the resin containers (step S3).

At this time, the exhaust unit 60 exhausts the source gas with which the storage rooms S1, S2, S3 and S4 are sequentially filled and which leaks out from the storage rooms one after another.

When the electric power switching part 85 initially electrically opens the second switch circuit 86B, and, on the other hand, closes the first switch circuit 86A after the source gas is supplied, the electric power from the high frequency power source 80 is supplied only to the first unit U1. By the supply of the electric power, plasma is generated between the first chamber 40A and the second chamber 40B serving as the outer electrodes and the internal electrodes 50 respectively introduced into the storage rooms S1 and S2 thereof. The internal electrodes 50 are electrically grounded. However, since the first and second chambers 40A and 40B are electrically insulated by the insulating plate 30, a potential difference arises between the first and second chambers 40A and 40B and the internal electrodes 50. Thus, in the two resin containers B stored in the first and second chambers 40A and 40B, the films are formed in inner surfaces thereof (step S4).

Then, after a film forming process to the resin containers B in the first and second chambers 40A and 40B is finished, the electric power switching part 85 subsequently carries out a switch switching operation to open the first switch circuit 86A, and, on the other hand, close the second switch circuit 86B. Accordingly, the electric power from the high frequency power source 80 is supplied only to the second unit U2. Thus, plasma is generated in the third and fourth chambers 40C and 40D to form films in inner surfaces in the two resin containers B stored in these chambers 40C and 40D (step S5).

Namely, by such a continuous operation of the electric power switching part 85, the plasma is sequentially generated for each of the predetermined units (for each of the first and second units U1 and U2 in the present embodiment), and finally, the films are formed in the inner surfaces of all the resin containers B (four in the present embodiment) (step S6).

As described above, according to the resin container coating device 10 of the present embodiment, since the electric power switching part 85, which can switch the supply destination of the high frequency electric power supplied from the high frequency power source 80 to the third and fourth chambers 40C and 40D forming the second unit U2 from the first and second chambers 40A and 40B forming the first unit U1, is provided, the film forming process by the generation of plasma can be sequentially carried out to the plurality of resin containers B. Namely, initially, the high frequency electric power is supplied to a part of the plurality of chambers 40A, 40B, 40C and 40D, that is, the first and second chambers 40A and 40B of the first unit U1 to carry out the film forming process to the resin containers B stored in the part of the chambers. Then, the supply destination of the high frequency electric power is switched by the electric power switching part 85, so that the film forming process can be carried out to the resin containers B stored in the remaining chambers, namely, the chambers 40C and 40D of the second unit U2. In such a way, when the film forming process is sequentially carried out for each of the predetermined units of the plurality of chambers 40A, 40B, 40C and 40D, the high frequency electric power required for the film forming process at one time can be suppressed and the high frequency power source 80 does not need to be enlarged.

Further, according to the resin container coating device 10 of the present embodiment, since common pretreatments such as a process of evacuating the plurality of chambers 40A, 40B, 40C and 40D or a process of supplying the source gas to the plurality of chambers 40A, 40B, 40C and 40D can be carried out together to the plurality of chambers 40A, 40B, 40C and 40D at the same time, production efficiency can be improved.

Further, according to the resin container coating device 10 of the present embodiment, since the high frequency electric power (for instance, the high frequency electric power slightly higher than that of ordinary film forming conditions) can be supplied only to the chambers of the one unit of the plurality of chambers 40A, 40B, 40C and 40D, for instance, when a uniform film is hardly formed due to the sizes or forms of the resin containers B, conditions can be variously changed to inspect an optimum manufacturing condition. Thus, the present invention can be also employed for an experimental use to set conditions.

### (Second Embodiment)

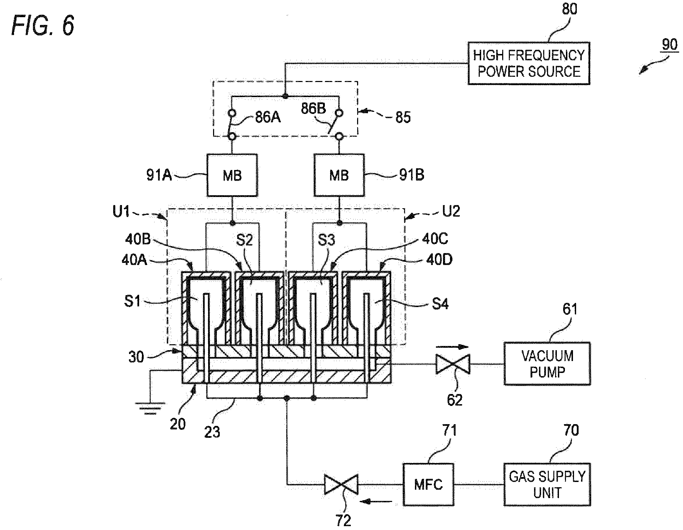

Next, by referring to Fig. 6, a second embodiment of a resin container coating device according to the present invention will be described below. An explanation of the same as or equivalent to those of the above-described first embodiment will be omitted or simplified by attaching the same or equivalent reference numerals to the drawings.

The present embodiment is different from the first embodiment, and a matching box is not provided between a high frequency power source 80 and an electric power switching part 85. Each of two matching boxes 91A and 91B is arranged between first and second units U1 and U2 and the electric power switching part 85.

According to the resin container coating device 90, since the two matching boxes 91A and 91B are respectively arranged in one to each unit between the first and second units U1 and U2 and the electric power switching part 85, an impedance matching which respectively meets the units U1 and U2 can be more accurately carried out. Thus, unevenness in quality of a film of resin containers B can be more suppressed. Further, even when a difference in impedance is large between the first and second units U1 and U2 due to any cause, since the impedance matching is individually carried out in the present embodiment, if an adjustment of the matching boxes 91A and 91B is set once, the adjustment does not need to be newly carried out afterward. Accordingly, an efficiency of an operation can be improved. Other configurations and operational effects are the same as those of the above-described first embodiment.

### (Third Embodiment)

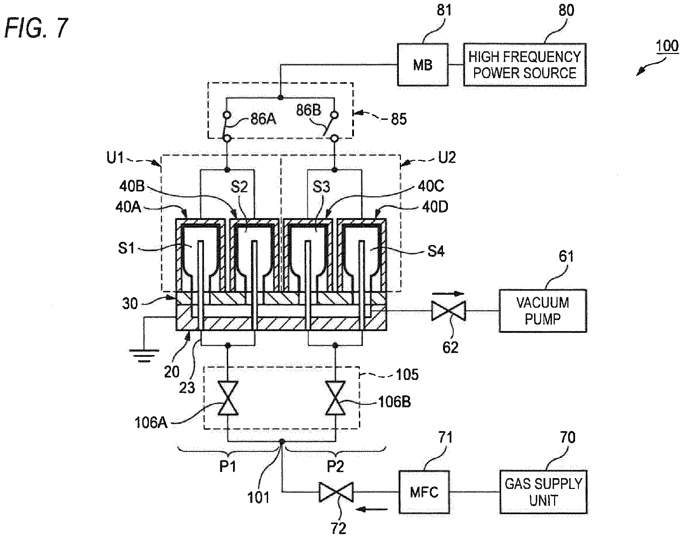

Now, by referring to Fig. 7, a third embodiment of a resin container coating device according to the present invention will be described below.

An explanation of the same as or equivalent to those of the above-described first embodiment will be omitted or simplified by attaching the same or equivalent reference numerals to the drawings.

In the present embodiment, as shown in Fig. 7, a gas branch part 101 is provided at a downstream side of an on-off valve 72 viewed from a gas supply unit 70. Thus, first and second gas supply passages P1 and P2 are formed so as to be independent of each other. The first gas supply passage P1 is a passage which supplies source gas to the first and second chambers 40A and 40B forming a first unit U1. The second gas supply passage P2 is a passage which supplies the source gas to the third and fourth chambers 40C and 40D forming a second unit U2. In the first and second gas supply passages PI and P2, on-off valves 106A and 106B are respectively arranged in intermediate parts of the passages.

More specifically, the on-off valves 106A and 106B are respectively arranged between gas passage paths 23 of a base part 20 and the gas branch part 101 to carry out operations of supplying the source gas or stopping the supply of the source gas correspondingly to a switch switching operation of an electric power switching part 85. Namely, only to one of the first and second unit U1 and U2 sides to which the electric power switching part 85 supplies an electric power, one of the first or second on-off valve 106A or 106B which corresponds thereto opens the gas supply passage P1 or P2 thereof at a predetermined timing to supply the source gas. Then, when the electric power switching part 85 switches the supply of the electric power to the other unit U1 or U2, one of the on-off valves 106A and 106B is closed and the other is opened so as to correspond thereto so that the supply of the source gas is switched. Namely, these on-off valves 106A and 106B form a gas switching part 105.

According to the resin container coating device 100, the gas switching part 105 is further provided which can alternately switch a supply destination of the source gas supplied from the gas supply unit 70 to the chambers 40C and 40D forming the second unit U2 from the first and second chambers 40A and 40B forming the first unit U1 among the plurality of chambers 40A, 40B, 40C and 40D. Namely, in the gas supply unit 70 side, the gas branch part 101 is provided to form the first and second gas supply passages P1 and P2 which respectively supply the source gas to the first and second units U1 and U2. In these gas supply passages P1 and P2, the on-off valves 106A and 106 are respectively provided. Accordingly, when films are formed on inner surfaces of the resin containers B, the source gas can be supplied merely to a necessary unit (U1, U2). Thus, the wastefulness of the source gas to be used can be reduced and a production cost can be reduced.

Other configurations and operational effects are the same as those of the above-described first embodiment.

The present invention is not limited to the above-described embodiments and may be suitably modified and improved. For instance, the configuration of the second embodiment (the configuration that the matching boxes are respectively provided for each unit) and the configuration of the third embodiment (the configuration that the gas supply passages and the on-off valves are respectively provided for each unit) may be combined together to form a device. Further, although a configuration in which four chambers are divided into two units is exemplified, the number of the chambers or the units is not limited to the embodiments and may be suitably set.

### Description of Reference Numerals and Signs

10, 90, 100: resin container coating device,
20: base part,
21: bottom plate part,
22: screw hole,
23: gas passage path,
25: peripheral wall part,
30: insulating plate,
40A, 40B, 40C, 40D: chamber,
41A, 41B, 41C, 41D: chamber body,
42A, 42B, 42C, 42D: through hole,
43: container holding part,
43A: opening part,
44: air exhaust opening,
45A, 45B, 45C, 45D: chamber lid,
46A, 46B, 46C, 46D: bottomed hole,
50: internal electrode,
51: gas conductive part,
52: piping member,
60: exhaust unit,
61: vacuum pump,
62: on-off valve,
70: gas supply unit,
71: mass flow controller,
72: on-off valve,
80: high frequency power source,
81: matching box,
85: electric power switching part,
86A: first switch circuit,
86B:second switch circuit,
91A: first matching box,
91B: second matching box,
105: gas switching part,
106A: first on-off valve,
106B: second on-off valve,
P1: first gas supply passage,
P2: second gas supply passage,
S1, S2, S3, S4: storage room,
S5: inner space,
U1: first unit,
U2: second unit

## Claims

1. A resin container coating device (10, 90, 100) comprising:
a plurality of chambers (40A, 40B, 40C, 40D), each of the plurality of chambers (40A, 40B, 40C, 40D) serving as a respective one of a plurality of outer electrodes which are mutually electrically independent, and each of the plurality of chambers (40A, 40B, 40C, 40D) storing a respective one of a plurality of resin containers (B) in independent states;
a plurality of internal electrodes (50) which are electrically grounded and formed in a tubular shape, in which gas conductive parts (51) for conducting a source gas are formed to inner peripheral parts thereof, and which are respectively inserted inside the plurality of resin containers (B) stored in the chambers (40A, 40B, 40C, 40D);
a gas supply unit (70) for supplying the source gas to the plurality of chambers (40A, 40B, 40C, 40D);
a high frequency power source (80) for supplying a high frequency electric power to the plurality of chambers (40A, 40B, 40C, 40D);
an electric power switching part (85) capable of switching a supply designation of the high frequency electric power, which is supplied from the high frequency power source (80), from a part of the plurality of chambers (40A, 40B, 40C, 40D) to another chamber (40A, 40B, 40C, 40D); and
a gas switching part (105) capable of switching a supply destination of the source gas, which is supplied from the gas supply unit (70), from a part of the plurality of chambers (40A, 40B, 40C, 40D) to another chamber (40A, 40B, 40C, 40D);
wherein the resin container coating device (10, 90, 100) is configured so that an operation of switching the supply destination of the source gas by the gas switching part (105) is carried out correspondingly to an operation of switching the supply designation of the high frequency electric power by the electric power switching part (85).

## Patentansprüche

1. Harzbehälterbeschichtungsvorrichtung (10, 90, 100), die Folgendes umfasst:
eine Vielzahl an Kammern (40A, 40B, 40C, 40D), wobei jede der Vielzahl an Kammern (40A, 40B, 40C, 40D) als jeweils eine einer Vielzahl an äußeren Elektroden dient, die voneinander elektrisch unabhängig sind, und wobei jede der Vielzahl an Kammern (40A, 40B, 40C, 40D) einen entsprechenden der Vielzahl an Harzbehältern (B) in voneinander unabhängigen Zuständen umfasst;
eine Vielzahl an inneren Elektroden (50), die elektrisch mit Masse verbunden sind und in einer Rohrform gebildet sind, in denen gasführende Teile (51) zum Leiten eines Ausgangsgases zu inneren peripheren Teilen davon gebildet sind und, die jeweils in das Innere der Vielzahl an Harzbehältern (B) eingebracht sind, die in den Kammern (40A, 40B, 40C, 40D) gelagert sind;
eine Gaszufuhreinheit (70) für die Zufuhr des Ausgangsgases an die Vielzahl an Kammern (40A, 40B, 40C, 40D);
eine Hochfrequenz-Energiequelle (80) für die Zufuhr von hochfrequenter elektrischer Energie an die Vielzahl an Kammern (40A, 40B, 40C, 40D);
ein elektrisches Energieschaltteil (85), das in der Lage ist, ein Versorgungsziel der elektrischen Hochfrequenzenergie, die von der elektrischen Hochfrequenzenergiequelle (80) gespeist wird, aus einem Teil der Vielzahl an Kammern (40A, 40B, 40C, 40D) in eine andere Kammer (40A, 40B, 40C, 40D) umzuschalten; und
ein Gasschaltteil (105), das in der Lage ist, ein Versorgungsziel des Ausgangsgases, das aus der Gaszufuhreinheit (70) zugeführt ist, aus einem Teil der Vielzahl an Kammern (40A, 40B, 40C, 40D) in eine andere Kammer (40A, 40B, 40C, 40D) umzuschalten;
worin die Harzbehälterbeschichtungsvorrichtung (10, 90, 100) so konfiguriert ist, dass ein Umschaltvorgang des Versorgungsziels des Ausgangsgases durch das Gasschaltteil (105) entsprechend einem Umschaltvorgang des Versorgungsziels der elektrischen Hochfrequenzenergie durch das elektrische Energieschaltteil (85) durchgeführt wird.

## Revendications

1. Dispositif de revêtement de récipient en résine (10, 90, 100) comprenant :
une pluralité de chambres (40A, 40B, 40C, 40D), chacune de la pluralité de chambres (40A, 40B, 40C, 40D) ayant la fonction d'une électrode respective d'une pluralité d'électrodes externes qui sont mutuellement indépendantes électriquement, et chacune de la pluralité de chambres (40A, 40B, 40C, 40D) stockant un récipient respectif d'une pluralité de récipients en résine (B) dans des états indépendants ;
une pluralité d'électrodes internes (50) qui sont mises à la terre électriquement et formées selon une forme tubulaire, dans lesquelles des parties conductrices de gaz (51) pour conduire un gaz source sont formées sur des parties périphériques internes de celles-ci, et qui sont respectivement insérées à l'intérieur de la pluralité de récipients en résine (B) stockés dans les chambres (40A, 40B, 40C, 40D) ;
une unité d'alimentation en gaz (70) pour alimenter en gaz source la pluralité de chambres (40A, 40B, 40C, 40D) ;
une source d'énergie à haute fréquence (80) pour fournir une énergie électrique à haute fréquence à la pluralité de chambres (40A, 40B, 40C, 40D) ;
une partie de commutation d'énergie électrique (85) capable de commuter une destination d'alimentation de l'énergie électrique à haute fréquence, qui est fournie à partir de la source d'énergie à haute fréquence (80), depuis une partie de la pluralité de chambres (40A, 40B, 40C, 40D) vers une autre chambre (40A, 40B, 40C, 40D) ; et
une partie de commutation de gaz (105) capable de commuter une destination d'alimentation du gaz source, qui est fourni à partir de l'unité d'alimentation en gaz (70), depuis une partie de la pluralité de chambres (40A, 40B, 40C, 40D) vers une autre chambre (40A, 40B, 40C, 40D) ;
dans lequel le dispositif de revêtement de récipient en résine (10, 90, 100) est configuré de telle sorte qu'une opération de commutation de la destination d'alimentation du gaz source au moyen de la partie de commutation de gaz (105) est effectuée en correspondance avec une opération de commutation de la destination d'alimentation de l'énergie électrique à haute fréquence au moyen de la partie de commutation d'énergie électrique (85).
